# EUROPEAN PATENT APPLICATION

(11) **EP 3 076 009 A2**
(43) Date of publication of application: **05.10.2016**
(21) Application number: 16157433.0
(22) Date of filing: 25.02.2016
(51) Int. Cl.: F02P 9/00, F02P 11/00, F02P 3/055, H02M 1/08, H03K 17/16

(54) **SEMICONDUCTOR DEVICE**

(30) Priority: 09.03.2015 JP 2015045936; 15.01.2016 JP 2016005696
(71) Applicant: Fuji Electric Co., Ltd., Kawasaki-shi 210-9530 (JP)
(72) Inventor: MIYAZAWA, Shigemi, Kawasaki-shi, Kanagawa 210-9530 (JP)
(74) Representative: MERH-IP Matias Erny Reichl Hoffmann Patentanwälte PartG mbB

(57) **Abstract**

When a normal operation is detected by a self-interruption signal source and a first transistor is on, if an on-signal is inputted to an IN terminal, a second transistor is turned on and a third transistor is turned off. Accordingly, an IGBT is turned on. In this state, if an abnormality is detected by the self-interruption signal source, the second transistor is turned off and the third transistor is turned on. Accordingly, a gate terminal of the IGBT is connected to an emitter terminal via the first and third transistors, and charges accumulated by gate capacitance of the IGBT are rapidly discharged. Consequently, if a comparator detects that a collector voltage of the IGBT has exceeded a predetermined voltage, the first transistor is turned off, and gradual interruption in which the charges accumulated by the gate capacitance are gradually released by a resistor is performed.

## Description

### FIELD

The embodiments discussed herein relate to a semiconductor device used in an ignition device of an automotive internal combustion engine.

### BACKGROUND

An ignition device of an automotive internal combustion engine primarily includes an ignition coil that generates a high voltage, an ignition integrated circuit (IC) that controls switching of the primary-side current of the ignition coil, and a spark plug. This ignition IC includes a power semiconductor element that is connected in series with the primary coil of the ignition coil and a drive circuit that drives the power semiconductor element on the basis of a signal inputted from an engine control unit (ECU). The ignition IC also includes a self-interruption circuit that turns off the power semiconductor element and interrupts the current flowing through the ignition coil when an abnormality is caused in the ignition IC or the power semiconductor element. For example, if the drive circuit allows a current to flow through the power semiconductor element continuously over a predetermined period, an abnormality is caused. In another case, if the power semiconductor element is overheated, an abnormality is cuased.

If such an abnormality is detected, the self-interruption circuit turns off the power semiconductor element and interrupts the current flowing through the ignition coil. Thus, the current flowing through the ignition coil could rapidly change irrespective of the signal inputted from the ECU. As a result, the secondary-side voltage of the ignition coil could rapidly change, and the spark plug could discharge an electric current unexpectedly. If this happens, for example, the engine could cause abnormal combustion and could be damaged.

To address such problem, soft-off control is known (for example, see Japanese Laid-open Patent Publication Nos. 2008-45514 and 2006-37822). According to this technique, when an abnormality is detected and self-interruption is performed, the current flowing through the primary side of the ignition coil is gradually changed and interrupted. In this way, the spark plug is prevented from erroneously discharging an electric current at any timing.

According to the technique in Japanese Laid-open Patent Publication No. 2008-45514, resistors and a constant current circuit are connected to the gate terminal of a power semiconductor element, and the gate voltage at an ON level is gradually decreased when an abnormality is detected. In addition, according to the technique in Japanese Laid-open Patent Publication No. 2006-37822, the gate voltage of a power semiconductor is gradually decreased by controlling a self-interruption transistor on the basis of a signal outputted from an integration circuit formed by the reverse leakage resistance of a diode and a capacitor. As described above, by performing gradual interruption in which the gate voltage of a power semiconductor element is gradually decreased, the primary-side current of an ignition coil is gradually changed. Consequently, since the secondary-side current of the ignition coil is gradually changed, abnormal ignition by the spark plug is prevented.

Next, an example of a specific configuration of an ignition IC including the above self-interruption function will be described.

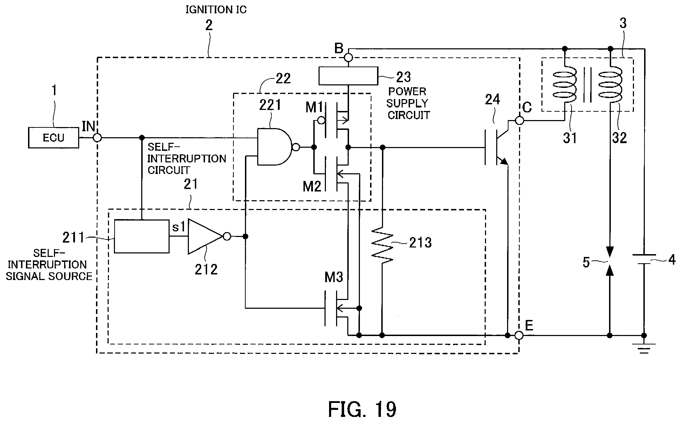

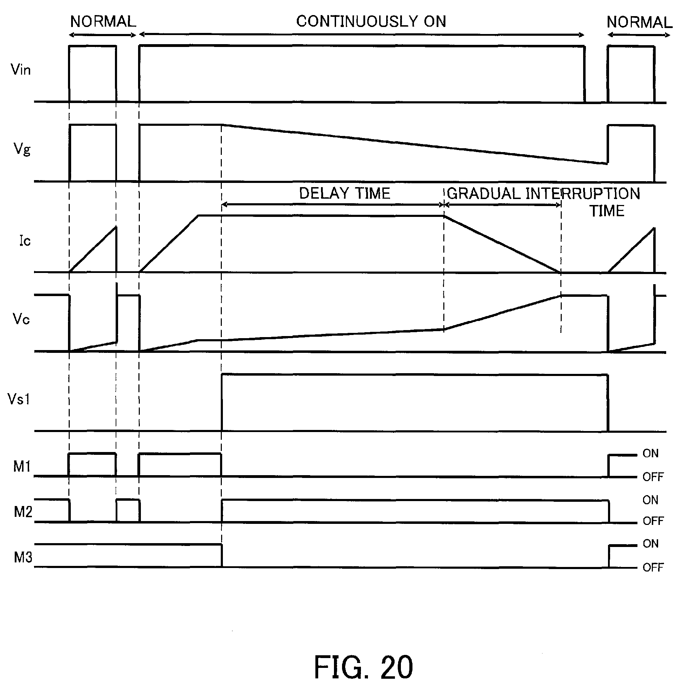

FIG. 19 illustrates an exemplary configuration of an ignition device of an automotive internal combustion engine, the configuration including an exemplary configuration of a conventional ignition IC 2. FIG. 20 illustrates exemplary waveforms of operations of the conventional ignition IC 2.

As illustrated in FIG. 19, the ignition device includes an ECU 1 that comprehensively controls the ignition device, the ignition IC 2 as an ignitor, an ignition coil 3 formed by winding a primary coil 31 and a secondary coil 32 around an iron core, a power supply (battery) 4, and a spark plug 5. The ignition IC 2 uses an insulated gate bipolar transistor (IGBT) 24 as a power semiconductor element that turns on and off the primary-side current of the ignition coil 3.

The ignition IC 2 includes a collector terminal (C terminal) connected to the ignition coil 3, an emitter terminal (E terminal) connected to the ground potential, an input terminal (IN terminal) connected to the ECU 1, and a power supply terminal (B terminal) connected to the power supply 4.

The C terminal of the ignition IC 2 is connected to one terminal of the primary coil 31 of the ignition coil 3. The other terminal of the primary coil 31 is connected to the positive electrode terminal of the power supply 4. The E terminal of the ignition IC 2 is connected to the ground. One terminal of the secondary coil 32 of the ignition coil 3 is connected to one electrode of the spark plug 5, and the other terminal of the secondary coil 32 is connected to the positive electrode terminal of the power supply 4. The other electrode of the spark plug 5 and the negative electrode terminal of the power supply 4 are connected to the ground.

The ignition IC 2 also includes a drive circuit 22 that drives the IGBT 24, a self-interruption circuit 21, and a power supply circuit 23. The drive circuit 22 includes a NAND circuit 221, a transistor M1 as a gate pull-up circuit, and a transistor M2 as a gate pull-down circuit. The transistor M1 is a p-type metal-oxide-semiconductor field-effect transistor (MOSFET), and the transistor M2 is an n-type MOSFET. Each of the transistors M1 and M2 has a switching function. One input terminal of the NAND circuit 221 is connected to the IN terminal, and the output teminal of the NAND circuit 221 is connected to the gate terminals of the transistors M1 and M2, which are the control terminals of the transistors M1 and M2 forming an inverter in the form of a complementary circuit. The drain terminals of the transistors M1 and M2 are connected to the gate terminal of the IGBT 24. The source terminal of the transistor M1 is connected to an output teminal of the power supply circuit 23.

The power supply circuit 23 converts the voltage (for example, 14 volts (V)) of the power supply 4 into a voltage (for example, 5 V) and serves as a power supply for the drive circuit 22 and the self-interruption circuit 21.

The self-interruption circuit 21 includes a self-interruption signal source 211, an inverter 212, an n-type MOSFET M3 that serves as a switch circuit, and a resistor 213. The self-interruption signal source 211 is an abnormality detection circuit that detects an abnormality of the conducting state of the IGBT 24. For example, the self-interruption signal source 211 has a timer function and a temperature detection function for detecting abnormal electrical conduction and overheat of the IGBT 24. The output terminal of the self-interruption signal source 211 is connected to the input terminal of the inverter 212, and the output terminal of the inverter 212 is connected to the other input terminal of the NAND circuit 221 of the drive circuit 22 and to the gate terminal of the transistor M3. The drain terminal of the transistor M3 is connected to the source terminal of the transistor M2 of the drive circuit 22, and the source terminal of the transistor M3 is connected to the E terminal of the ignition IC 2. One terminal of the resistor 213 is connected to the gate terminal of the IGBT 24, and the other terminal of the resistor 213 is connected to the E terminal of the ignition IC 2. The resistor 213 forms a minute current circuit that pulls charges accumulated by the gate capacitance of the IGBT 24.

Next, operations of the ignition device of the automotive internal combustion engine will be described with reference to FIGS. 19 and 20. The ECU 1 outputs a signal Vin that controls on and off of the IGBT 24 to the IN terminal of the ignition IC 2. For example, to turn on the IGBT 24, the ECU 1 outputs an on-signal, which is a high (H) level voltage signal Vin (5 V), to the IN terminal. In contrast, to turn off the IGBT 24, the ECU 1 outputs an off-signal, which is a low (L) level voltage signal Vin (0 V), to the IN terminal. The self-interruption signal source 211 of the self-interruption circuit 21 outputs a self-interruption signal s1. In a normal operation, Vs1 represents an L level, and in an abnormal operation, Vs1 represents an H level. Thus, in a normal operation, the self-interruption signal s1 is inverted by the inverter, and the H-level signal is supplied to the other input terminal of the NAND circuit 221 and to the gate terminal of the transistor M3. Namely, the NAND circuit 221 operates as an inverter with respect to the signal inputted from the ECU 1, and the transistor M3 is maintained on in a normal operation.

First, when the on-signal is inputted to the IN terminal of the ignition IC 2, the NAND circuit 221 outputs an L-level signal. Accordingly, the transistor M1 is turned on and the transistor M2 is turned off. As a result, the drive circuit 22 turns on the IGBT 24 by pulling up a gate voltage Vg of the gate terminal of the IGBT 24 to 5 V. Consequently, a collector current Ic starts to flow from the power supply 4 through the C terminal of the ignition IC 2 via the primary coil 31 of the ignition coil 3. Regarding this collector current Ic, dIc/dt is determined by the inductance of the primary coil 31 and the voltage applied to the primary coil 31. The collector current Ic is increased up to a constant current value (for example, 17 amperes (A)) that is determined by the resistance of the primary coil 31, the on-resistance of the IGBT 24, and the voltage of the power supply 4. Regarding a collector voltage Vc at the C terminal of the ignition IC 2 (strictly speaking, this collector voltage Vc is a voltage between the collector and the emitter), when the IGBT 24 is turned on and the collector current Ic starts to flow, the voltage applied by the power supply 4 is instantaneously decreased. Subsequently, the collector voltage Vc is gradually increased due to the on-resistance of the IGBT 24.

Next, when the off-signal is inputted to the IN terminal of the ignition IC 2, the NAND circuit 221 outputs an H-level signal. Accordingly, the transistor M1 is turned off and the transistor M2 is turned on. Thus, the drive circuit 22 turns off the IGBT 24 by pulling down the gate voltage Vg at the gate terminal of the IGBT 24 to 0 V. Consequently, the collector current Ic is rapidly decreased, and the collector voltage Vc is rapidly increased. This rapid change of the collector current Ic rapidly increases the voltage across the primary coil 31. Simultaneously, the voltage across the secondary coil 32 is rapidly increased (for example, up to 30 kV). As a result, the increased voltage is applied to the spark plug 5. The spark plug 5 discharges an electric current when the applied voltage reaches about 10 kV or more. Subsequently, the collector voltage Vc is decreased back to the voltage of the power supply 4. The above operation corresponds to the portion indicated by "NORMAL" in FIG. 20.

If the on-signal of the ECU 1 is outputted for more than a predetermined period or if the ignition IC 2 or the IGBT 24 is overheated, the ignition coil 3 or the ignition IC 2 could be damaged by heat. Namely, a malfunction could occur. In such a case, the self-interruption circuit 21 operates to interrupt the collector current Ic. However, if the collector current Ic is rapidly interrupted, the spark plug 5 could discharge an electric current unexpectedly and cause damage to the engine. Thus, the self-interruption circuit 21 needs to control |dIc/dt| in such a manner that the spark plug 5 does not erroneously discharge an electric current (for example, a current of 1 A changed per millisecond (ms)).

Next, a case in which an abnormality occurs will be described. In this case, too, at first, the gate voltage Vg, the collector current Ic, and the collector voltage Vc of the IGBT 24 behave in the same way as in the normal operation. The gate voltage Vg is increased to the H level, and the collector current Ic is increased and maintained at the constant current value (for example, 17 A). The collector voltage Vc is increased gradually.

If a timer circuit (not illustrated) detects that the on-signal has continuously been inputted for a predetermined period or longer or if a temperature detection circuit (not illustrated) detects overheat, the self-interruption signal source 211 outputs an H-level self-interruption signal s1 indicating an abnormality. If the self-interruption signal source 211 outputs an H-level self-interruption signal s1 (Vs1 = H level in FIG. 20), the inverter 212 applies an L-level signal to the other input terminal of the NAND circuit 221 and to the gate terminal of the transistor M3. Accordingly, since the signal outputted from the output terminal of the NAND circuit 221 is fixed at the H level, the transistor M1 is turned off and the transistor M2 is turned on. Since the transistor M3 connected in series with the transistor M2 is supplied with the L-level gate signal and is turned off, the charges accumulated by the gate capacitance of the IGBT 24 are gradually discharged via the resistor 213. As a result, when the gate voltage Vg of the IGBT 24 is gradually decreased and reaches a predetermined voltage or lower, the collector current Ic starts to decrease and the collector voltage Vc starts to increase.

As described above, if an abnormality occurs, for example, if the on-signal Vin is continuously outputted from the ECU 1, after the self-interruption signal source 211 outputs the H-level self-interruption signal s1, the gate voltage Vg of the IGBT 24 is decreased at a constant rate. When the gate voltage Vg of the IGBT 24 is decreased to the predetermined voltage, the collector current Ic starts to decrease gradually. Namely, gradual interruption is started.

With this ignition IC 2, as described above, after the self-interruption signal source 211 outputs the self-interruption signal s1, the charges accumulated by the gate capacitance of the IGBT 24 are gradually discharged, and the gate voltage Vg is decreased at a constant rate. While the collector current Ic is decreased with the decrease of the gate voltage Vg, the decrease of the collector current Ic is not constant because of electrical characteristics of the IGBT. More specifically, while the rate of the decrease of the collector current Ic is very small until the gate voltage Vg is decreased to a certain level, the rate of the decrease of the collector current Ic becomes larger after the gate voltage Vg is decreased to the certain level. In other words, the collector current Ic is not effectively decreased until the gate voltage Vg is decreased to the certain level. Namely, the effective decrease of the collector current Ic is delayed until the gate voltage Vg is decreased to the certain level. During the delay time, since a certain large current (for example, a current close to 17 A) continues to flow through the IGBT 24 and the primary coil 31, the IGBT 24 and the primary coil 31 could be damaged by heat or the like. To avoid such damage, sensitivity for detection of an abnormality needs to be increased, for example, by shortening the setting time of the timer in view of the delay time or by decreasing the detection temperature. However, if such countermeasures are taken, there is a problem that self-interruption is easily performed. In addition, to suppress the heat generation caused by a large current that flows during the delay time, the thermal resistance of the ignition IC 2 needs to be decreased. However, the chip size needs to be increased in such case.

### SUMMARY

The embodiments have been made in view of such circumstances, and it is an object of the present invention to provide a semiconductor device capable of suppressing heat generation in a power semiconductor element and a primary coil of an ignition coil by shortening the delay time caused until the decrease of a current flowing through the primary coil is practically started when self-interruption is performed.

In one aspect of the embodiments, there is provided a semiconductor device that controls switching of a power semiconductor element, the semiconductor device including: a gate pull-up circuit configured to be connected to a gate terminal of the power semiconductor element and pull up a voltage of the gate terminal based on an input signal; a gate pull-down circuit configured to be connected to the gate terminal of the power semiconductor element and pull down the volage of the gate terminal based on the input signal; an abnormality detection circuit configured to detect an abnormality of a conducting state of the power semiconductor element; a minute current circuit configured to be connected to the gate terminal of the power semiconductor element and pull charges from gate capacitance of the power semiconductor element; a voltage detection circuit configured to be connected to a collector terminal of the power semiconductor element and detect a collector voltage; and a switch circuit configured to be connected between the gate pull-down circuit and an emitter terminal of the power semiconductor element, wherein, when the abnormality detection circuit detects an abnormality, the gate pull-up circuit is interrupted, the gate pull-down circuit is brought in a conducting state, and charges are pulled from the gate capacitance of the power semiconductor element via the switch circuit, and wherein, when the voltage detection circuit detects that the collector voltage increased by the pulling of the charges has exceeded a set value, the switch circuit is interrupted, and the charges are pulled by the minute current circuit.

### BRIEF DESCRIPTION OF DRAWINGS

FIG. 1 illustrates an exemplary configuration of an ignition device of an automotive internal combustion engine, the configuration including an exemplary configuration of an ignition IC according to a first embodiment;
FIG. 2 illustrates exemplary waveforms of operations of the ignition IC according to the first embodiment;
FIG. 3 illustrates current-voltage characteristics of an IGBT;
FIG. 4 is a time chart illustrating transition of an operating point when self-interruption is performed;
FIG. 5 is a circuit diagram illustrating an exemplary configuration of a self-interruption signal source;
FIG. 6 illustrates waveforms of operations of a reset circuit;
FIG. 7 illustrates waveforms of operations of the self-interruption signal source;
FIG. 8 illustrates an exemplary configuration of an ignition device of an automotive internal combustion engine, the configuration including an exemplary configuration of an ignition IC according to a second embodiment;
FIG. 9 illustrates an exemplary configuration of an ignition device of an automotive internal combustion engine, the configuration including an exemplary configuration of an ignition IC according to a third embodiment;
FIG. 10 illustrates an exemplary configuration of an ignition device of an automotive internal combustion engine, the configuration including an exemplary configuration of an ignition IC according to a fourth embodiment;
FIG. 11 illustrates a variation of the above exemplary configuration of the ignition IC according to the fourth embodiment;
FIG. 12 illustrates an exemplary configuration of an ignition device of an automotive internal combustion engine, the configuration including an exemplary configuration of an ignition IC according to a fifth embodiment;
FIG. 13 illustrates an exemplary configuration of an ignition device of an automotive internal combustion engine, the configuration including an exemplary configuration of an ignition IC according to a sixth embodiment;
FIG. 14 illustrates an exemplary configuration of an ignition device of an automotive internal combustion engine, the configuration including an exemplary configuration of an ignition IC according to a seventh embodiment;
FIG. 15 illustrates an exemplary configuration of an ignition device of an automotive internal combustion engine, the configuration including an exemplary configuration of an ignition IC according to an eighth embodiment;
FIG. 16 illustrates an exemplary configuration of an ignition device of an automotive internal combustion engine, the configuration including an exemplary configuration of an ignition IC according to an ninth embodiment;
FIG. 17 illustrates an exemplary configuration of an ignition device of an automotive internal combustion engine, the configuration including an exemplary configuration of an ignition IC according to a tenth embodiment;
FIG. 18 illustrates an exemplary configuration of an ignition device of an automotive internal combustion engine, the configuration including an exemplary configuration of an ignition IC according to an eleventh embodiment;
FIG. 19 illustrates an exemplary configuration of an ignition device of an automotive internal combustion engine, the configuration including an exemplary configuration of a conventional ignition IC; and
FIG. 20 illustrates exemplary waveforms of operations of the conventional ignition IC.

### DESCRIPTION OF EMBODIMENTS

Hereinafter, several embodiments of the present invention will be described in detail with reference to the accompanying drawings by using, as an example, an ignition control IC that is used in an ignition device of an automotive internal combustion engine and that includes a self-interruption function. Throughout the drawings, like reference characters refer to like elements. In the following description, constituent elements that are the same as or equivalent to those in FIG. 19 will be denoted by the same reference characters, and detailed description thereof will be omitted. In addition, an individual embodiment may be realized by combining a plurality of embodiments, as long as the combination does not cause contradiction.

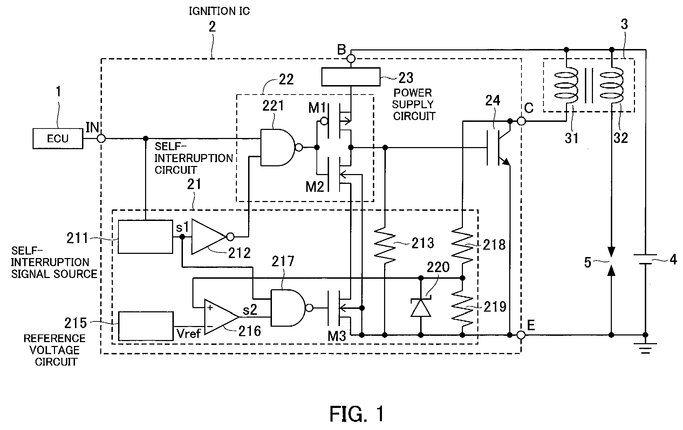

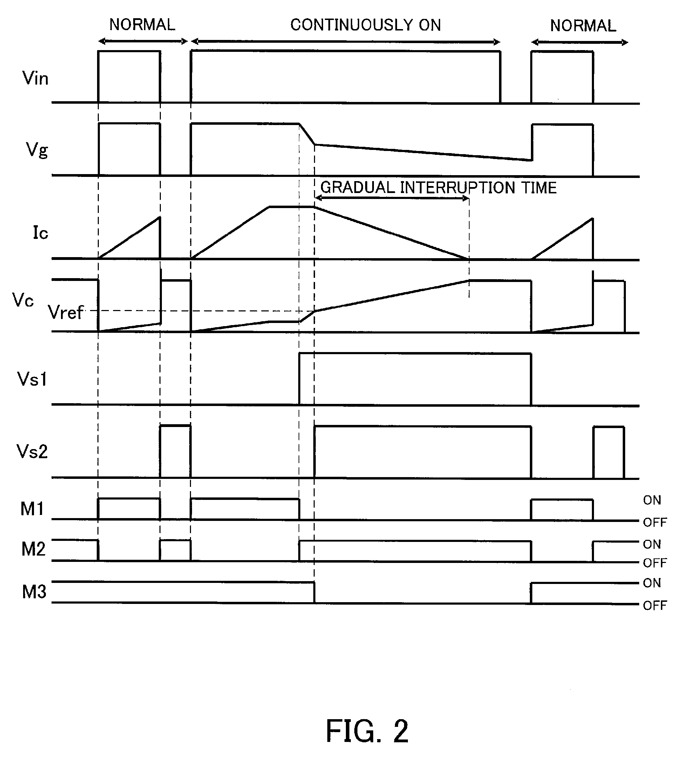

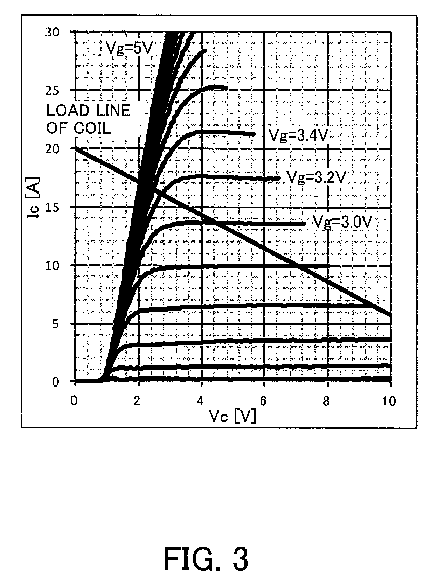

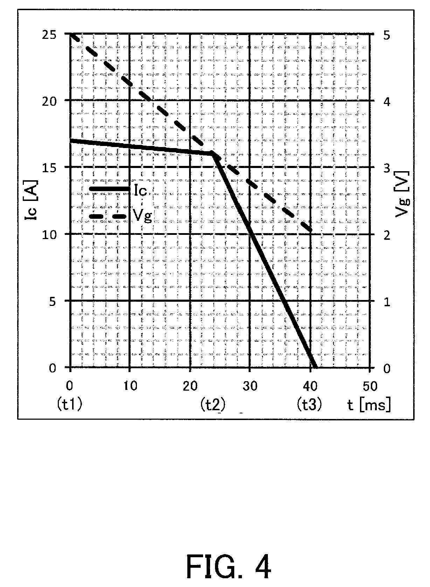

FIG. 1 illustrates an exemplary configuration of an ignition device of an automotive internal combustion engine, the configuration including an exemplary configuration of an ignition IC according to a first embodiment. FIG. 2 illustrates exemplary waveforms of operations of the ignition IC according to the first embodiment. FIG. 3 illustrates current-voltage characteristics of an IGBT. FIG. 4 is a time chart illustrating transition of an operating point when self-interruption is performed.

As illustrated in FIG. 1, the self-interruption circuit 21 of the ignition IC 2 according to the first embodiment is configured differently, compared with that illustrated in FIG. 19. More specifically, the self-interruption circuit 21 additionally includes a reference voltage circuit 215, a comparator 216, a NAND circuit 217, resistors 218 and 219, and a Zener diode 220. As is the case with the configuration illustrated in FIG. 19, the power supply circuit 23 serves as a power supply for the drive circuit 22 and the self-interruption circuit 21.

The output terminal of the reference voltage circuit 215 is connected to the inverting input terminal of the comparator 216, and the output terminal of the comparator 216 is connected to one input terminal of the NAND circuit 217. The other input terminal of the NAND circuit 217 is connected to the output terminal of the self-interruption signal source 211, and the output terminal of the NAND circuit 217 is connected to the gate terminal of the transistor M3. One terminal of the resistor 218 is connected to the C terminal of the ignition IC 2, and the other terminal of the resistor 218 is connected to one terminal of the resistor 219. The other terminal of the resistor 219 is connected to the E terminal of the ignition IC 2. The connecting point of the resistors 218 and 219 is connected to the non-inverting input terminal of the comparator 216 and to the cathode terminal of the Zener diode 220. The anode terminal of the Zener diode 220 is connected to the E terminal of the ignition IC.

The resistors 218 and 219 connected in series with each other form a voltage divider. For example, the resistors 218 and 219 have the same resistance value and outputs a voltage value, which is 50% of the collector voltage Vc (Vc/2) at the C terminal. The reference voltage circuit 215 outputs a predetermined reference voltage Vref. In this way, the resistors 218 and 219, the reference voltage circuit 215, the comparator 216, and the NAND circuit 217 form a voltage detection circuit for detecting the collector voltage Vc. If the collector voltage Vc exceeds a predetermined value corresponding to the reference voltage Vref, the comparator 216 outputs a signal s2 (outputs an H-level signal Vs2 in FIG. 2).

The comparator 216 does not directly detect the collector voltage Vc. Instead, the comparator 216 detects a voltage obtained by causing the resistors 218 and 219 to divide the collector voltage Vc. In this way, even when the collector voltage Vc exceeds the withstand voltage of the comparator 216, the comparator 216 is able to perform its detection operation. In addition, the Zener diode 220 is arranged to protect circuits such as the comparator 216. Even when the collector voltage Vc exceeds the withstand voltage of the comparator 216, the Zener diode 220 is able to protect circuits such as the comparator 216. The reverse withstand voltage of the Zener diode 220 is set to be larger than the predetermined value corresponding to the reference voltage Vref compared with 50% of the collector voltage Vc.

With the configuration described above, when the self-interruption signal source 211 does not output the self-interruption signal s1, namely, in a normal operation in which the signal Vs1 in FIG. 2 is at an L level, the ignition IC 2 operates in the same way as that described with reference to FIGS. 19 and 20.

Next, an operation performed, for example, when the self-interruption signal source 211 detects an abnormality in which the IGBT 24 is continuously on and the self-interruption signal source 211 continuously outputs the self-interruption signal s1 (outputs an H-level signal Vs1 in FIG. 2) will be described. In such a case, immediately after receiving the on-signal (the H-level signal Vin) from the ECU 1, the ignition IC 2 operates in the same way as in the normal operation. However, if the on-signal is continuously inputted, the collector current Ic is increased and is maintained at a predetermined current value (for example, 17 A). Accordingly, the collector voltage Vc is gradually increased and is maintained.

When the self-interruption signal source 211 outputs an H-level self-interruption signal s1, an L-level signal is inputted to the NAND circuit 221 via the inverter 212. Thus, the NAND circuit 221 outputs an H-level signal, and the transistor M1 is turned off and the transistor M2 is turned on. At this point, while the self-interruption signal source 211 in the self-interruption circuit 21 is still outputting an H-level signal Vs1, since the collector voltage Vc has not reached the predetermined value corresponding to the reference voltage Vref, the transistor M3 is still on. Since the transistors M2 and M3 are on, the charges accumulated by the gate capacitance of the IGBT 24 are released via the transistors M2 and M3, and the gate voltage Vg of the IGBT 24 is rapidly decreased. Accordingly, the collector voltage Vc is rapidly increased.

When the collector voltage Vc exceeds the predetermined value, the output terminal of the comparator 216 outputs an H-level signal Vs2. As a result, the transistor M3 is turned off. Next, the ignition IC 2 switches to a gradual interruption operation in which the charges accumulated by the gate capacitance of the IGBT 24 are released via the resistor 213.

As described above, with this ignition IC 2, when the self-interruption circuit 21 detects an abnormality and performs self-interruption, first, the self-interruption circuit 21 performs rapid interruption as in normal interruption. Subsequently, if the collector voltage Vc exceeds a certain value, the self-interruption circuit 21 performs gradual interruption. In this way, since the delay time between the occurrence of an abnormality and the start of the gradual interruption is very short, the heat generation caused at the IGBT 24 and the ignition coil 3 during the delay time is suppressed.

Next, why such rapid interruption is possible before gradual interruption will be described. FIG. 3 illustrates current-voltage characteristics of the IGBT 24 having general output characteristics as a power semiconductor element of the ignition IC 2. In FIG. 3, the vertical axis represents the collector current Ic and the horizontal axis represents the collector voltage Vc. FIG. 3 indicates a relationship between the collector current Ic and the collector voltage Vc when the gate voltage Vg is changed. In FIG. 3, the load line of the ignition coil 3 is also drawn. This load line is drawn assuming that the power supply 4 is 14 V and the resistance of the primary coil 31 is 0.7 ohms (Ω), for example. The intersection point of this load line and an individual current-voltage curve represents an operating point of the IGBT 24. For example, when the gate voltage Vg is 5 V, the collector current Ic is 17 A and the collector voltage Vc is 2 V. When load interruption is performed, the operating point moves in the lower right direction on the load line from the gate voltage Vg = 5 V to the gate threshold voltage 2 V as the gate voltage Vg decreases.

The IGBT 24 is operated by changing the gate voltage Vg. Thus, the decrease of the gate voltage Vg on the load line at a constant rate is indicated in the time chart in FIG. 4. The decrease of the gate voltage Vg at a constant rate corresponds to the release of the charges accumulated by the gate capacitance by the resistor 213 when self-interruption is performed, as is the case with the circuit in FIG. 19. In FIG. 4, the vertical axes represent the gate voltage Vg and the collector current Ic, and the horizontal axis represents time. The change of the gate voltage Vg over time is indicated by a dashed line, and the change of the collector current Ic over time is indicated by a solid line. As illustrated in FIG. 4, from time t1, which corresponds to the start of self-interruption, to time t2, namely, when the gate voltage Vg is decreased from 5 V to 3.2 V, the collector current Ic is decreased by approximately 1 A. However, from time t2 to time t3, the gate voltage Vg is decreased from 3.2 V to 2 V, and the collector current Ic is decreased by approximately 16 A.

Hereinafter, |dIc/dt| < 1 A/ms, which is a condition about the change of the collector current Ic over time that does not result in ignition by the spark plug 5 when self-interruption is performed, will be examined. While the collector current Ic is decreased only by 1 A within 24 ms between time t1 and time t2, the collector current Ic is decreased by 16 A within 16 ms between time t2 and time t3. Namely, while the decrease rate of the collector current Ic from time t2 to time t3 approximately satisfies the above condition, too much time is needed from time t1 to time t2. This period of time corresponds to the delay time illustrated in FIG. 20. The finding signifies that the time needed for the collector current Ic to decrease by 1 A can be shortened to approximately 1 ms.

According to the present invention, the time (between time t1 and time t2) needed for the collector current Ic to decrease from 17 A to 16 A is shortened, and the delay time as illustrated in FIG. 20 is substantially eliminated.

To explain this, ranges in which the change of the collector current Ic is small and large with respect to the change of the gate voltage Vg will be defined as follows, in view of the I-V characteristics of the power semiconductor to which load is set. Namely, the gate voltage Vg between the small and large ranges, a collector voltage corresponding to the gate voltage, and a collector current corresponding to the gate voltage will be referred to as a gate voltage threshold Vgth, a collector voltage threshold Vcth, and a collector current threshold Icth, respectively.

More specifically, the collector voltage and the gate voltage at time t2 in FIG. 4 correspond to the collector voltage threshold Vcth and the gate voltage threshold Vgth, respectively. The period from time t1 to time t2 corresponds to the range in which the change of the collector current Ic is small with respect to the change of the gate voltage Vg, and the period from time t2 to time t3 corresponds to the range in which the change of the collector current Ic is large with respect to the change of the gate voltage Vg (note that the collector voltage Vc increases as the gate voltage Vg decreases).

In the first embodiment, after the self-interruption signal source 211 outputs the H-level self-interruption signal s1, the ignition IC 2 performs rapid interruption until the collector voltage Vc reaches the collector voltage threshold Vcth and performs gradual interruption after the collector voltage Vc reaches the collector voltage threshold Vcth. Thus, the value of the resistors 218 and 219 for dividing the collector voltage Vc and the reference voltage Vref are set so that whether the collector voltage Vc has exceeded the collector voltage threshold Vcth is detected. Namely, a voltage that appears at the connecting point of the resistors 218 and 219 when the collector voltage Vc reaches the collector voltage threshold Vcth is set to be the reference voltage Vref. The value of the resistors 218 and 219 may be set after the reference voltage Vref is set so that a voltage that appears at the connecting point of the resistors 218 and 219 when the collector voltage Vc reaches the collector voltage threshold Vcth corresponds to the reference voltage Vref.

In other words, the collector current Ic at time t2 is converted into and detected as the collector voltage Vc on the basis of the current-voltage characteristics in FIG. 3. After the start of self-interruption, the ignition IC 2 performs rapid interruption until the corresponding value is detected and performs gradual interruption after the corresponding value is detected. More specifically, in the example in FIG. 3, when the collector current Ic is 16 A, the value of collector voltage Vc on the load line is approximately 2.4 V. Thus, the voltage division ratio of the resistors 218 and 219 and the reference voltage Vref of the reference voltage circuit 215 are set so that the comparator 216 outputs the H-level voltage Vs2 when the collector voltage Vc is 2.4 V. In the above example, since this voltage division ratio is set to 1/2, the reference voltage Vref is set to approximately 1.2 V.

It is desirable that the reference voltage Vref be set to be sufficiently larger than a noise level, to prevent the comparator 216 from erroneously operating with a noise voltage. The reference voltage Vref is smaller than the voltage supplied by the power supply circuit 23.

The control operation in the first embodiment may be viewed as a control operation that uses a phenomenon in which, after the IGBT 24 is set to on and pinch-off in which the collector current Ic is saturated is reached, the collector voltage Vc is rapidly increased. In this control, when the collector voltage starts to increase, the ignition IC 2 starts gradual interruption.

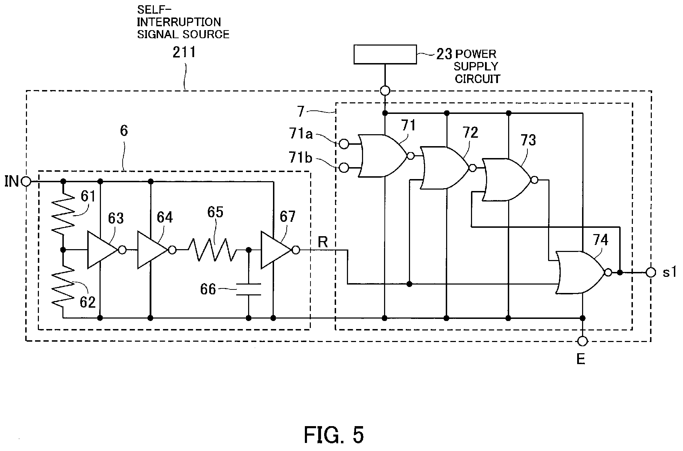

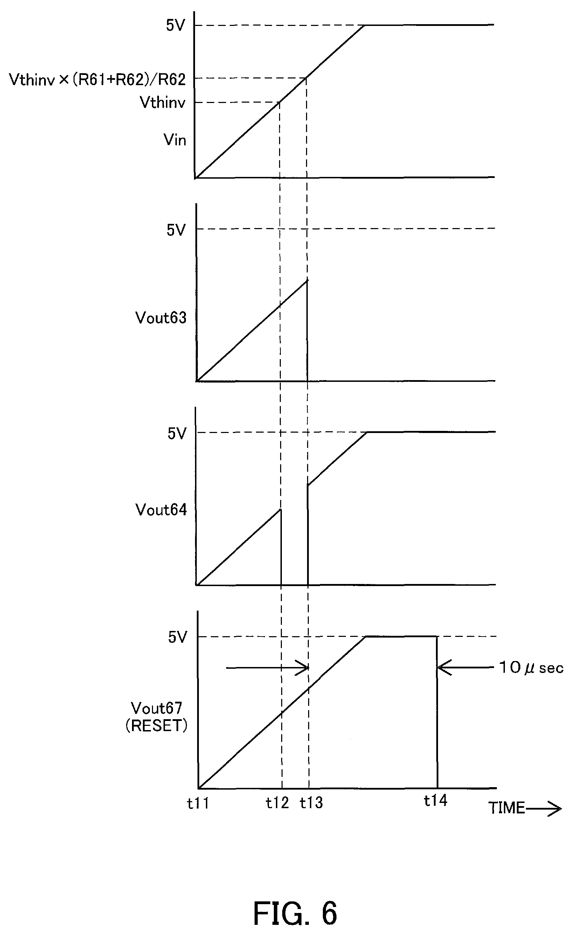

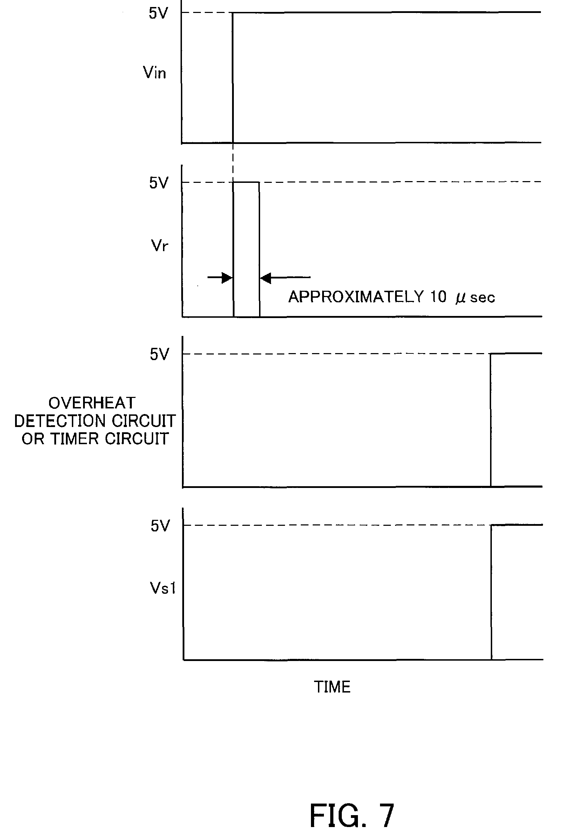

FIG. 5 is a circuit diagram illustrating an exemplary configuration of the self-interruption signal source 211. FIG. 6 illustrates waveforms of operations of a reset circuit. FIG. 7 illustrates waveforms of operations of the self-interruption signal source 211.

The self-interruption signal source 211 includes a reset circuit 6 and a latch circuit 7. In the reset circuit 6, resistors 61 and 62 are connected in series with each other between the IN terminal and the E terminal. The connecting point of the resistors 61 and 62 is connected to one terminal of a resistor 65 via inverters 63 and 64. The other terminal of the resistor 65 is connected to one terminal of the capacitor 66, and the other terminal of the capacitor 66 is connected to the E terminal. The other terminal of the resistor 65 is also connected to the input terminal of the inverter 67, and the output terminal of the inverter 67 forms an output terminal that outputs a reset signal R of the reset circuit 6. The on-signal (H-level signal Vin) inputted from the ECU 1 via the IN terminal serves as a power supply for the inverters 63, 64, and 67 of the reset circuit 6.

The latch circuit 7 includes four NOR circuits 71 to 74, each of which receives power from the power supply circuit 23. The NOR circuits 73 and 74 form an RS flip-flop circuit, and the NOR circuits 71 and 72 form a circuit for shaping a waveform of a set signal from the RS flip flop circuit. Namely, the NOR circuit 73 has an output terminal connected to one input terminal of the NOR circuit 74, and the NOR circuit 74 has an output terminal connected to one input terminal of the NOR circuit 73. The NOR circuit 74 has the other input terminal connected to the output terminal of the reset circuit 6. The output terminal of the NOR circuit 74 is connected to the output terminal that outputs the self-interruption signal s1, and the other input terminal of the NOR circuit 73 is connected to the output terminal of the NOR circuit 72. One input terminal of the NOR circuit 72 is connected to the output teminal of the NOR circuit 71, and the other input terminal of the NOR circuit 72 is connected to the terminal from which the NOR circuit 74 receives the reset signal R. The NOR circuit 71 has input terminals 71a and 71b. These input terminals 71a and 71b are connected to a timer circuit and temperature detection circuit (not illustrated). If the ECU 1 continuously inputs an on-signal (H-level signal Vin) to the IN terminal over a predetermined period, the timer circuit outputs an H-level signal. In addition, if the temperature of the IGBT 24 or the ignition IC 2 exceeds a predetermined temperature, the temperature detection circuit outputs an H-level signal.

With the above self-interruption signal source 211, if the IN terminal has continuously received the on-signal (H-level signal Vin) over the predetermined period, the reset circuit 6 outputs the reset signal R. FIG. 6 illustrates an operation of the reset circuit 6 performed when the on-signal is inputted to the IN terminal and the voltage Vin rises. In FIG. 6, the time axis is expanded. In addition, the threshold voltage of the inverters 63, 64, and 67 is indicated by Vthinv, and the resistance values of the resistors 61 and 62 are indicated by R61 and R62. The output voltages of the inverters 63, 64, and 67 are indicated by Vout63, Vout64, and Vout67, respectively.

In FIG. 6, the on-signal is inputted at time t11, and the voltage Vin reaches the threshold voltage Vthinv of the inverters 63, 64, and 67 at time t12. Until time t12, all the inverters 63, 64, and 67 outputs a voltage equal to the voltage Vin.

Next, when the voltage Vin is between Vthinv and Vthinv x (R61 + R62)/R62 (between time t12 and time t13), the output voltage Vout63 of the inverter 63 is over the threshold voltage Vthinv of the inverter 64. Thus, by the amount of the output from the inverter 64, the output voltage Vout64 is decreased to be an L level (for example, 0 V).

Next, immediately after the voltage Vin exceeds Vthinv x (R61 + R62)/R62, the output voltage Vout64 of the inverter 64 is increased to be equal to the voltage Vin. However, because of the time constant of the resistor 65 and capacitor 66 arranged downstream of the inverter 64, it takes time for the input voltage of the inverter 67 to reach the threshold voltage Vthinv. More specifically, the output voltage Vout67 of the inverter 67 reaches an L level (for example, 0V) at time t14. The delay time between time t13 and time t14 is approximately 10 µ sec, for example.

Thus, as illustrated in FIG. 7, each time the on-signal (H-level signal Vin) is inputted to the IN terminal, the reset circuit 6 generates, for example, a reset signal R (voltage Vr) whose on-width is 10 µ sec, and outputs the reset signal R to the latch circuit 7.

When the latch circuit 7 receives the reset signal R, the RS flip-flop circuit formed by the NOR circuits 73 and 74 is reset, and the latch circuit 7 outputs the L-level self-interruption signal s1 (Vs1) to its output terminal. This operation assumes that the input terminal 71a or 71b of the NOR circuit 71 has received an L-level signal indicating normality from the timer circuit or the temperature detection circuit.

If the timer circuit or the temperature detection circuit detects an abnormality and outputs an H-level signal indicating the abnormality to the input terminal 71a or 71b of the NOR circuit 71, the signal is transmitted to the NOR circuit 73 via the NOR circuit 72. As a result, the RS flip-flop circuit formed by the NOR circuits 73 and 74 is set, and the latch circuit 7 outputs the H-level self-interruption signal s1 (Vs1) to its output terminal.

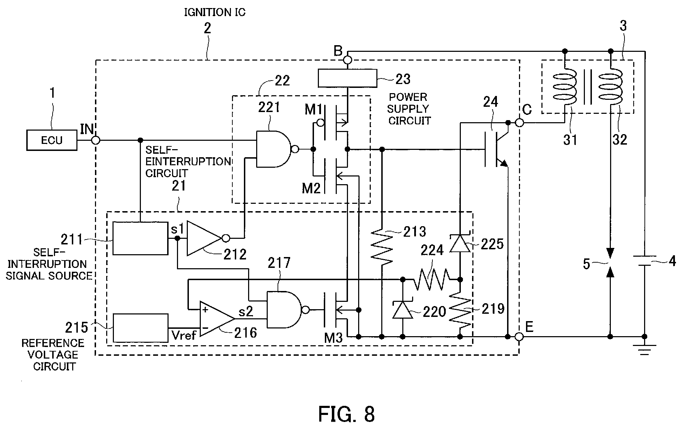

FIG. 8 illustrates an exemplary configuration of an ignition device of an automotive internal combustion engine, the configuration including an exemplary configuration of an ignition IC 2 according to a second embodiment. In FIG. 8, constituent elements that are the same as or equivalent to those in FIG. 1 will be denoted by the same reference characters, and detailed description thereof will be omitted.

The ignition IC 2 according to the second embodiment is different from that according to the first embodiment in the circuit for detecting the collector voltage Vc in the self-interruption circuit 21. Namely, the self-interruption circuit 21 includes a Zener diode 225 and the resistor 219 that are connected in series with each other between the C and E terminals. The connecting point of the Zener diode 225 and the resistor 219 is connected to the non-inverting input terminal of the comparator 216 via a resistor 224, and the Zener diode 220 is connected between the non-inverting input terminal of the comparator 216 and the E terminal.

The reverse withstand voltage of the Zener diode 225 may be set to be smaller than the collector voltage Vc, which is to be detected based on the reference voltage Vref, and to be close to the collector voltage Vc. The Zener diode 220 protects the comparator 216 from a high voltage, and the reverse withstand voltage of the Zener diode 220 is set to be sufficiently larger than the reference voltage Vref and sufficiently smaller than the withstand voltage of the comparator 216. The resistor 224 protects the Zener diode 220 from an overcurrent.

With this ignition IC 2, when the collector voltage Vc exceeds the reverse withstand voltage of the Zener diode 225, a current flows through the resistor 219, and a voltage appears across the resistor 219. This voltage is applied to the non-inverting input terminal of the comparator 216. The resistor 219 also has a function of protecting the Zener diode 225 from an overcurrent.

Other operations of this ignition IC 2 are the same as those of the ignition IC 2 illustrated in FIG. 1, except the method for detecting the collector voltage Vc. In the second embodiment, the collector voltage Vc that needs to be detected is also the collector voltage threshold Vcth, as in the first embodiment.

Next, the method for detecting the collector voltage Vc according to the second embodiment will be described. When the collector voltage Vc exceeds the collector voltage threshold Vcth, the Zener diode 225 is brought in a conducting state, and a current starts to flow through the resistor 219. Because of this current, a voltage appears at the connecting point of the Zener diode 225 and the resistor 219. The comparator 216 compares this voltage with the reference voltage Vref to detect whether the collector voltage Vc has exceeded the collector voltage threshold Vcth.

Namely, for this reason, for example, the reverse withstand voltage of the Zener diode 225 may be set to be the same as or close to the collector voltage Vc that is to be detected based on the reference voltage Vref, namely, to be the same as or close to the collector voltage threshold Vcth.

If the reverse withstand voltage of the Zener diode 225 is set to be the same as the collector voltage threshold Vcth, the comparator 216 performs the following detection operation. Namely, when the collector voltage Vc exceeds the collector voltage threshold Vcth, the Zener diode 225 is brought in a conduction state, and a current starts to flow through the resistor 219. As a result, a voltage appears across the resistor 219, and the voltage is applied to the non-inverting input terminal of the comparator 216. The reference voltage Vref may be set to be the same as or less than the voltage that appears across the resistor 219. For example, in this way, the comparator 216 is able to detect whether the collector voltage Vc has exceeded the collector voltage threshold Vcth. It is desirable that the resistance value of the resistor 219 be high so that, even when a small current flows through the Zener diode 225, the detection is performed. In addition, it is desirable that the reference voltage Vref be set to be sufficiently larger than a noise level, to prevent the comparator 216 from erroneously operating with a noise voltage.

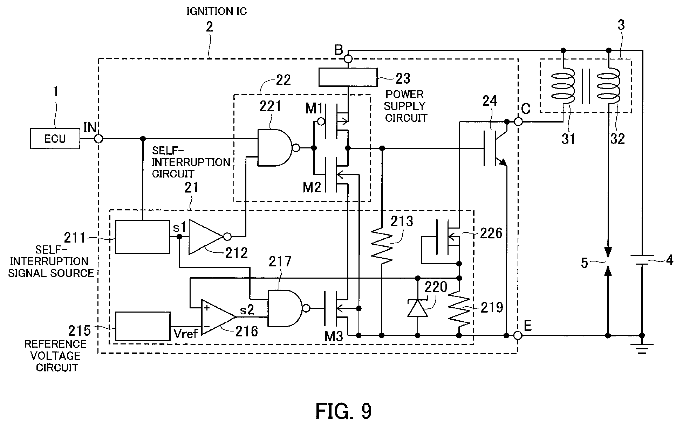

FIG. 9 illustrates an exemplary configuration of an ignition device of an automotive internal combustion engine, the configuration including an exemplary configuration of an ignition IC 2 according to a third embodiment. In FIG. 9, constituent elements that are the same as or equivalent to those in FIG. 1 will be denoted by the same reference characters, and detailed description thereof will be omitted.

The ignition IC 2 according to the third embodiment is different from the ignition IC 2 according to the first embodiment in the portion for detecting the collector voltage Vc in the self-interruption circuit 21. More specifically, the resistor 218 in the self-interruption circuit 21 according to the first embodiment is replaced by a depression metal-oxide semiconductor field-effect transistor (DepMOSFET) 226, which will simply be referred to as a DepMOS 226, as needed. The drain of the DepMOS 226 is connected to the collector of the IGBT 24 and the gate of the DepMOS 226 is connected to the source of the DepMOS 226. The source of the DepMOS 226 is connected to one end of the resistor 219. The other end of the resistor 219 is connected to the E terminal of the self-interruption circuit 21, as in the first embodiment.

Next, an operation of the self-interruption circuit 21 will be described. In this circuit, the DepMOS 226 operates as a resistor. Thus, the collector voltage Vc is divided by the on-resistance of the DepMOS 226 and the resistor 219, and a positive voltage is applied to the non-inverting input terminal of the comparator 216. Since the resistor 218 according to the first embodiment is merely replaced by the DepMOS 226, the basic operation according to the third embodiment is the same as that according to the first embodiment. In addition, as in the first embodiment, the Zener diode 220 is used as an overvoltage protection element for the comparator 216. However, unlike the first embodiment, the DepMOS 226 also protects the Zener diode 220 from an overcurrent. Namely, when the collector voltage is increased, the DepMOS 226 is saturated, and a saturated drain current (for example, 100 µA) of the DepMOS 226 starts to flow. In this way, the DepMOS 226 protects the Zener diode 220 from an overcurrent.

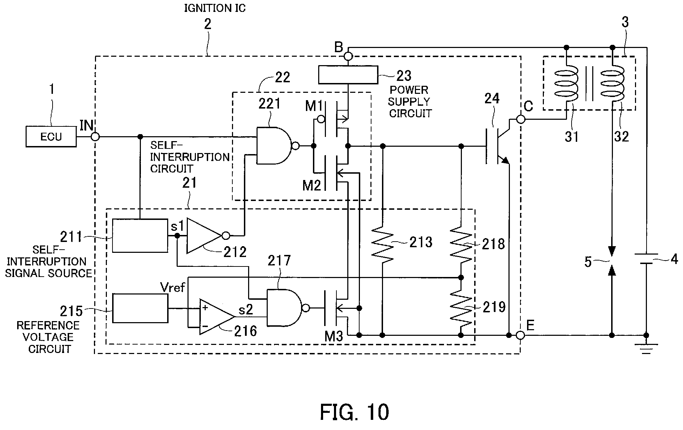

FIG. 10 illustrates an exemplary configuration of an ignition device of an automotive internal combustion engine, the configuration including an exemplary configuration of an ignition IC 2 according to a fourth embodiment. In FIG. 10, constituent elements that are the same as or equivalent to those in FIG. 1 will be denoted by the same reference characters, and detailed description thereof will be omitted.

While the ignition IC 2 according to the first embodiment detects the timing at which gradual interruption is started on the basis of the collector voltage Vc, the ignition IC 2 according to the fourth embodiment detects this timing on the basis of the gate voltage Vg of the IGBT 24. More specifically, in the self-interruption circuit 21 of the ignition IC 2, the resistors 218 and 219 connected in series with each other are arranged between the gate terminal of the IGBT 24 and the E terminal, and the connecting point of the resistors 218 and 219 is connected to the inverting input terminal of the comparator 216. In addition, in the self-interruption circuit 21, the output of the reference voltage circuit 215 is connected to the non-inverting input terminal of the comparator 216. In addition, the ignition IC 2 according to the fourth embodiment does not include the Zener diode 220, which is needed in the self-interruption circuit 21 in the ignition IC 2 according to the first embodiment and which protects the comparator 216 from an overvoltage.

In this embodiment, as described above, the timing at which gradual interruption is started is detected based on the gate voltage Vg of the IGBT 24. Namely, the present embodiment may be described as follows, by using the gate voltage threshold Vgth described in the description of the first embodiment.

After the self-interruption signal source 211 outputs an H-level self-interruption signal s1, the gate voltage Vg is decreased. Until the gate voltage Vg reaches the gate voltage threshold Vgth, the ignition IC 2 performs rapid interruption. After the gate voltage Vg falls below the gate voltage threshold Vgth, the ignition IC 2 performs gradual interruption. Thus, the value of the resistors 218 and 219 for dividing the gate voltage Vg and the reference voltage Vref are set so that whether the gate voltage Vg has fallen below the gate voltage threshold Vgth is detected.

With this self-interruption circuit 21, the gate voltage Vg of the IGBT 24 is divided by the resistors 218 and 219, and the divided voltage is applied to the inverting input terminal of the comparator 216. When the gate voltage Vg is decreased and the voltage applied to the inverting input terminal of the comparator 216 falls below the reference voltage of the reference voltage circuit 215, the output signal s2 of the comparator 216 is increased to the H level, and the ignition IC 2 starts gradual interruption. In the example illustrated in FIG. 4, when the gate voltage Vg is decreased from 5 V to 3.2 V, the logic output of the comparator 216 is inverted, the transistor M3 is turned off, and the ignition IC 2 starts gradual interruption. Other operations of this ignition IC 2 are the same as those of the ignition IC 2 illustrated in FIG. 1. Namely, in this embodiment, the operation for detecting the collector voltage illustrated in FIG. 1 is replaced by the operation for detecting the gate voltage Vg.

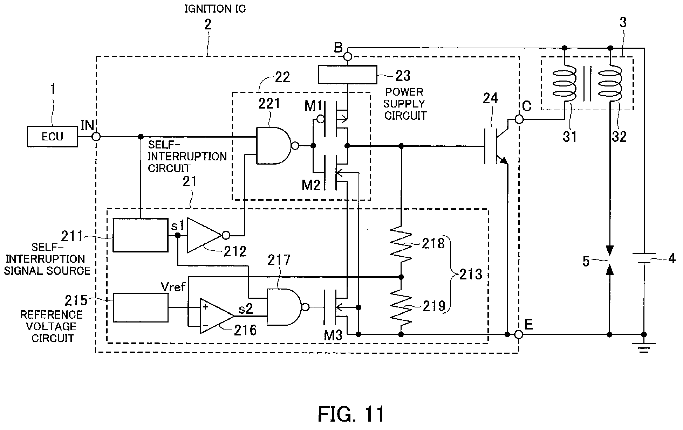

FIG. 11 illustrates a variation of the above exemplary configuration of the ignition IC according to the fourth embodiment.

In this variation, the resistor 213 illustrated in FIG. 10 is removed. While the resistor 213 serves as a minute current circuit in the above embodiments, the resistors 218 and 219 serve as the minute current circuit in this variation. The combined resistance of the resistors 218 and 219 serves as the resistor 213 according to the fourth embodiment. With this configuration, one resistor is eliminated. If this resistance is created on the chip of the ignition IC 2, the chip area is reduced, and consequently, the cost is reduced.

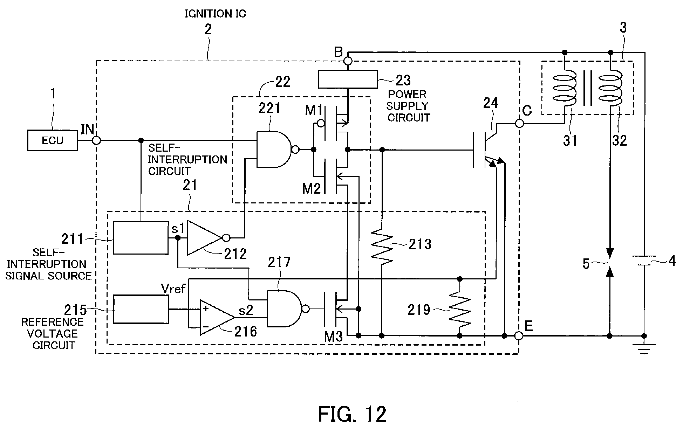

FIG. 12 illustrates an exemplary configuration of an ignition device of an automotive internal combustion engine, the configuration including an exemplary configuration of an ignition IC 2 according to a fifth embodiment. In FIG. 12, constituent elements that are the same as or equivalent to those in FIG. 1 will be denoted by the same reference characters, and detailed description thereof will be omitted.

While the ignition IC 2 according to the first embodiment detects the timing at which gradual interruption is started is detected based on the collector voltage Vc, the ignition IC 2 according to the fifth embodiment detects the timing based on the collector current Ic.

More specifically, the IGBT 24 of the ignition IC 2 includes a main element through which a main current flows and a current sensing element for detecting the current flowing through the main element. In addition, the collector and gate terminals of these elements are connected to each other. The emitter terminal of the main element of the IGBT 24 is connected to the E terminal, and the emitter terminal of the current sensing element is connected to one terminal of the resistor 219. The other terminal of the resistor 219 is connected to the E terminal. The connecting point of the emitter terminal of the current sensing element and the resistor 219 is connected to the inverting input terminal of the comparator 216, and the non-inverting input terminal of the comparator 216 is connected to the output of the reference voltage circuit 215 that generates the reference voltage Vref.

The timing at which the start of gradual interruption is detected by the ignition IC according to the present embodiment will be described by using the collector current threshold Icth described in the description of the first embodiment.

After the self-interruption signal source 211 outputs the H-level self-interruption signal s1, the ignition IC performs rapid interruption until the collector current Ic is decreased and reaches the collector current threshold Icth and performs gradual interruption after the collector current Ic falls below the collector current threshold Icth. Thus, the value of the resistor 219 that detects an emitter current Ise of the current sensing element corresponding to the collector current Ic of the main element and the reference voltage Vref are set so that whether the collector current Ic falls below the collector current threshold Icth is detected.

Namely, with this self-interruption circuit 21, the current outputted from the emitter terminal of the current sensing element of the IGBT 24 is converted into a voltage by the resistor 219, and the voltage is applied to the inverting input terminal of the comparator 216. The voltage obtained by the conversion performed by the resistor 219 has a value proportional to the collector current Ic. Namely, this self-interruption circuit 21 detects the timing at which gradual interruption is started based on the collector current Ic of the IGBT 24.

With this self-interruption circuit 21, when the collector current Ic is decreased and when the voltage applied to the inverting input terminal of the comparator 216 falls below the reference voltage of the reference voltage circuit 215, the output signal s2 of the comparator 216 is increased to the H level, and gradual interruption is started. In the example illustrated in FIG. 4, when the collector current Ic is decreased from the saturated current 17 A to 16 A, the logic output of the comparator 216 is inverted, and the transistor M3 is turned off. Consequently, gradual interruption is started. Other operations of this ignition IC 2 are the same as those of the ignition IC 2 illustrated in FIG. 1.

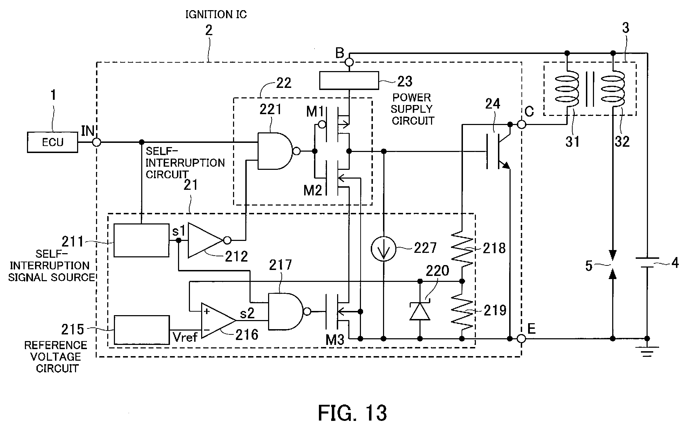

FIG. 13 illustrates an exemplary configuration of an ignition device of an automotive internal combustion engine, the configuration including an exemplary configuration of an ignition IC 2 according to a sixth embodiment. In FIG. 13, constituent elements that are the same as or equivalent to those in FIG. 1 will be denoted by the same reference characters, and detailed description thereof will be omitted.

The ignition IC 2 according to the sixth embodiment is different from the ignition IC 2 according to the first embodiment in that a constant current source 227 is used in place of the resistor 213 as an element for releasing the charges accumulated by the gate capacitance when gradual interruption is performed. Thus, this ignition IC 2 operates in the same way as the ignition IC 2 according to the first embodiment, except that the charges accumulated by the gate capacitance are released by the constant current source 227 when gradual interruption is performed.

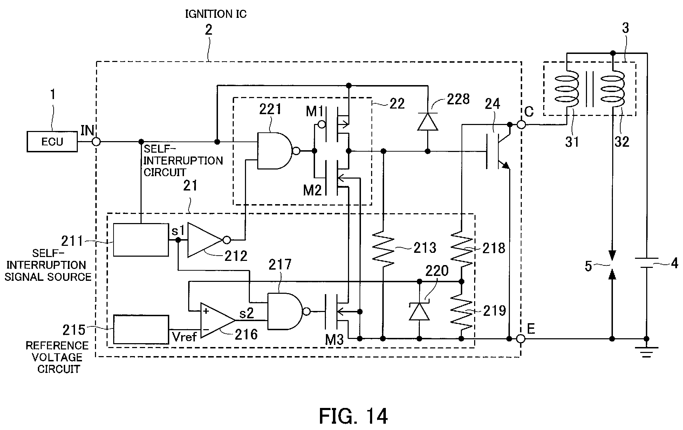

FIG. 14 illustrates an exemplary configuration of an ignition device of an automotive internal combustion engine, the configuration including an exemplary configuration of an ignition IC 2 according to a seventh embodiment. In FIG. 14, constituent elements that are the same as or equivalent to those in FIG. 1 will be denoted by the same reference characters, and detailed description thereof will be omitted.

The ignition IC 2 according to the seventh embodiment does not include the power supply circuit 23 and the B terminal included in the ignition IC 2 according to the first embodiment. However, this ignition IC 2 additionally includes a diode 228. The anode terminal of this diode 228 is connected to the gate terminal of the IGBT 24 and the cathode terminal thereof is connected to the IN terminal. The IN terminal is also connected to the source terminal of the transistor M1 in the drive circuit 22. While not illustrated, the positive power supply nodes of the circuit elements such as the self-interruption signal source 211, the reference voltage circuit 215, the comparator 216, the NAND circuits 217 and 221, and the inverter 212 used in the self-interruption circuit 21 and drive circuit 22 are also connected to the IN terminal. Namely, the power supply for the ignition IC 2 depends on a signal inputted to the IN terminal. There are cases in which an ignition IC called a single-chip igniter uses a signal inputted to its IN terminal as a power supply.

With this ignition IC 2, when an on-signal (H-level signal Vin) is inputted to the IN terminal, a voltage that is used as the power supply for the ignition IC and that is applied to the IN terminal is applied to the cathode of the diode 228, and a voltage lower than this voltage is applied to the anode of the diode 228. In this state, the diode 228 does not perform a particular function. Namely, the ignition IC 2 operates in the same way as the circuit according to the first embodiment.

In contrast, when an off-signal (L-level signal Vin) is inputted to the IN terminal, the power supply voltage in the circuit in the ignition IC 2 is decreased to zero. In this state, the diode 228 rapidly releases the charges accumulated by the gate capacitance of the IGBT 24 to the IN terminal side. Thus, while this ignition IC 2 receives its power supply from a signal inputted to the IN terminal, this ignition IC 2 operates in the same way as the ignition IC 2 according to the first embodiment.

Even when this mode described in the seventh embodiment, in which the power supply circuit 23 and the B terminal are removed from the ignition IC 2 and in which the diode 228 is newly added to the ignition IC 2, is applied to any one of the first to eighth embodiments, like advantageous effects are provided.

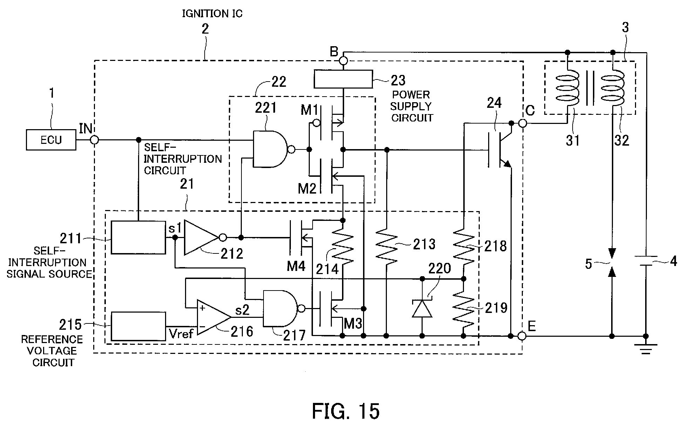

FIG. 15 illustrates an exemplary configuration of an ignition device of an automotive internal combustion engine, the configuration including an exemplary configuration of an ignition IC 2 according to an eighth embodiment. In FIG. 15, constituent elements that are the same as or equivalent to those in FIG. 1 will be denoted by the same reference characters, and detailed description thereof will be omitted. The ignition IC 2 according to the eighth embodiment includes a resistor 214 and a transistor M4 in addition to the elements included in the ignition IC 2 according to the first embodiment. The transistor M4 forms a first switch circuit that allows a current to flow in a normal operation and interrupts the current when an abnormality is detected. One terminal of the resistor 214 is connected to the source terminal of the transistor M2, and the other terminal of the resistor 214 is connected to the drain terminal of the transistor M3. The resistor 214 and the transistor M3 form a second switch circuit. The gate terminal of the transistor M4 is connected to the output terminal of the inverter 212, and the drain terminal of the transistor M4 is connected to the source terminal of the transistor M2. The source terminal of the transistor M4 is connected to the emitter terminal of the ignition IC 2. With this ignition IC 2 according to the eighth embodiment, after a normal on-signal is inputted in the IN terminal, if an off-signal (L-level signal Vin) is inputted to the IN terminal, the charges accumulated by the gate capacitance of the IGBT 24 is rapidly released via the transistors M2 and M4.

Next, if the self-interruption signal source 211 continues to output the self-interruption signal s1, the charges accumulated by the gate capacitance of the IGBT 24 are released via the transistor M2, the resistor 214, and the transistor M3 from time t1 when self-interruption is started to time t2 in FIG. 4. This discharge time is adjusted to be longer than the rapid interruption time (for example, 10 µs) in a normal operation and sufficiently shorter than the gradual interruption time (for example, 16 ms) by the resistance value of the resistor 214. From time t2 when gradual interruption in Fig. 4 is started to time t3, as in the first embodiment, the transistor M3 is turned off and the charges accumulated by the gate capacitance of the IGBT 24 are gradually released by the resistor 213. In this way, gradual interruption is performed.

In a normal operation, if the time for which the charges accumulated by the gate capacitance of the IGBT 24 are released is shorter, a larger voltage is applied to the spark plug 5. However, if the rate at which the gate voltage Vg of the IGBT 24 decreases from time t1 to time t2 in FIG. 4 is too low with respect to the circuit operation delay time from the detection of the collector voltage Vc to the interruption of the transistor M3, the IGBT 24 may completely be interrupted before switching to gradual interruption. Namely, the spark plug 5 may cause erroneous ignition.

With the ignition IC 2 according to the first embodiment, the voltage applied to the spark plug 5 in a normal interruption operation has a conflicting relationship with erroneous ignition caused by the spark plug 5 when self-interruption is performed. With the ignition IC 2 according to the eighth embodiment, the time from time t1 when self-interruption is started to time t2 in FIG. 4 is set to be, for example, 100 µs, which is longer than the rapid interruption time (for example, 10µs) in a normal operation, by using the resistor 214. In this way, it is possible to prevent erroneous ignition of the spark plug 5 while applying a large voltage to the spark plug 5 in normal interruption and preventing a large voltage from being applied to the spark plug 5 in self-interruption.

This mode described in the eighth embodiment, in which the path for releasing the charges accumulated by the gate capacitance of the IGBT 24 is switched among the time when normal interruption is performed, the time from time t1 when self-interruption is started to time t2 in FIG. 4, and the time from time t2 to time t3, is applicable not only to the first embodiment but also to any one of the second and third embodiments. In any of the cases, like advantageous effects are provided.

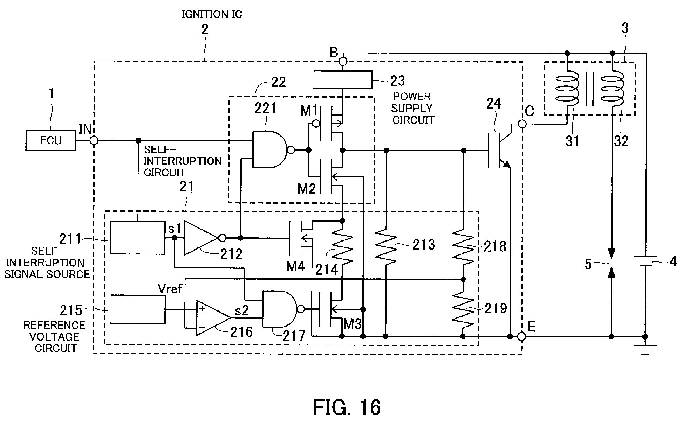

FIG. 16 illustrates an exemplary configuration of an ignition device of an automotive internal combustion engine, the configuration including an exemplary configuration of an ignition IC 2 according to a ninth embodiment. In FIG. 16, constituent elements that are the same as or equivalent to those in FIGS. 10 and 15 will be denoted by the same reference characters, and detailed description thereof will be omitted.

While the ignition IC 2 according to the eighth embodiment detects the gradual interruption start timing on the basis of the collector voltage Vc, the ignition IC 2 according to the ninth embodiment detects this timing on the basis of the gate voltage Vg of the IGBT 24. Namely, with the self-interruption circuit 21 of the ignition IC 2, as in the fourth embodiment illustrated in FIG. 10, the gate voltage Vg of the IGBT 24 is detected by the resistors 218 and 219 connected in series with each other between the gate terminal of the IGBT 24 and the E terminal. The comparator 216 compares the gate voltage Vg with the reference voltage Vref of the reference voltage circuit 215 corresponding to the gate voltage threshold Vgth. Thus, in this embodiment, the gradual interruption is started when the comparator 216 detects that the gate voltage Vg has fallen below the gate voltage threshold Vgth.

In this case, too, if the self-interruption signal source 211 continues to output the self-interruption signal s1, the charges accumulated by the gate capacitance of the IGBT 24 are released via the transistor M2, the resistor 214, and the transistor M3 from time t1 when self-interruption is started to time t2 in FIG. 4. Next, from time t2 when gradual interruption is started to time t3 in FIG. 4, the transistor M3 is turned off, and the charges accumulated by the gate capacitance of the IGBT 24 are gradually released by the resistor 213. In this way, gradual interruption is performed.

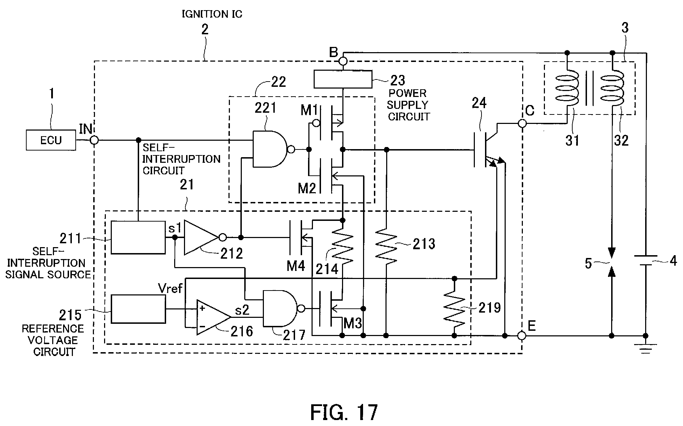

FIG. 17 illustrates an exemplary configuration of an ignition device of an automotive internal combustion engine, the configuration including an exemplary configuration of an ignition IC 2 according to a tenth embodiment. In FIG. 17, constituent elements that are the same as or equivalent to those in FIGS. 12 and 15 will be denoted by the same reference characters, and detailed description thereof will be omitted.

While the ignition IC 2 according to the eighth embodiment detects the gradual interruption start timing on the basis of the collector voltage Vc, the ignition IC 2 according to the tenth embodiment detects this timing on the basis of the collector current Ic. Namely, with the self-interruption circuit 21 of the ignition IC 2, as in the fifth embodiment illustrated in FIG. 12, the collector current is converted into a voltage by the current sensing element and the resistor 219. The comparator 216 compares the converted voltage with the reference voltage Vref of the reference voltage circuit 215 corresponding to the collector current threshold Icth. Thus, according to this embodiment, the gradual interruption is started when the comparator 216 detects that the collector current Ic has fallen below the collector current threshold Icth.

In this case, too, if the self-interruption signal source 211 continues to output the self-interruption signal s1, the charges accumulated by the gate capacitance of the IGBT 24 are released via the transistor M2, the resistor 214, and the transistor M3 from time t1 when self-interruption is started to time t2 in FIG. 4. Next, from time t2 when gradual interruption is started to time t3 in FIG. 4, the transistor M3 is turned off, and the charges accumulated by the gate capacitance of the IGBT 24 are gradually released by the resistor 213. In this way, gradual interruption is performed.

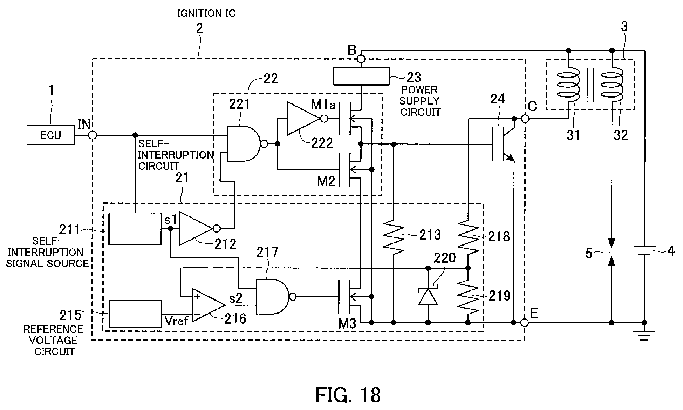

FIG. 18 illustrates an exemplary configuration of an ignition device of an automotive internal combustion engine, the configuration including an exemplary configuration of an ignition IC 2 according to an eleventh embodiment. In FIG. 18, constituent elements that are the same as or equivalent to those in FIG. 1 will be denoted by the same reference characters, and detailed description thereof will be omitted.

The ignition IC 2 according to the eleventh embodiment differs from the ignition IC 2 according to the first embodiment in the drive circuit 22. Namely, the drive circuit 22 according to the eleventh embodiment includes an n-type MOSFET M1a instead of the p-type MOSFET M1 and additionally includes an inverter 222 between the output terminal of the NAND circuit 221 and the gate terminal of the transistor M1a. The drain terminal of the transistor M1a is connected to the output terminal of the power supply circuit 23. The source terminal of the transistor M1a is connected to the gate terminal of the IGBT 24 and the drain terminal of the transistor M2. The inverter 222 inverts and outputs a logic value outputted from the NAND circuit 221.

With this ignition IC 2, when an on-signal is inputted to the IN terminal, the NAND circuit 221 outputs an L-level signal, and accordingly, the inverter 222 outputs an H-level signal. As a result, the transistor M1a is turned on, and the transistor M2 is turned off. In contrast, when an off-signal is inputted to the IN terminal, the NAND circuit 221 outputs an H-level signal, and accordingly, the inverter 222 outputs an L-level signal. As a result, the transistor M1a is turned off, and the transistor M2 is turned on.

Other operations of this ignition IC 2 are the same as those of the ignition IC 2 illustrated in FIG. 1.

In this mode in which the n-type MOSFET M1a is used instead of the p-type MOSFET M1 and the inverter 222 is added, only n-type MOSFETs may be used for all the MOSFETs constituting the transistors M1a and M2 and other logic circuits. More specifically, such an n-type MOSFET is formed as follows. While the IGBT 24 having an n-type semiconductor layer as a drift layer is formed, a p-type semiconductor region is formed on a surface layer of the n-type semiconductor layer in the same substrate. In addition, an n-type source region and a n-type drain region forming an n-type MOSFET are formed on a surface layer of the p-type semiconductor region. A gate electrode is formed on an n-type semiconductor layer between the source and drain regions via a gate insulating film.

The present embodiment is applicable not only to the first embodiment but also to any one of the second to tenth embodiments. In any of the cases, like advantageous effects are provided.

With a semiconductor device configured as described above, when an abnormality occurs, rapid interruption is performed first and gradual interruption is performed next. Thus, since the delay time caused until the gradual interruption is started is shortened, heat generation caused during the delay time is suppressed.

## Claims

1. A semiconductor device that controls switching of a power semiconductor element, the semiconductor device comprising:
a gate pull-up circuit configured to be connected to a gate terminal of the power semiconductor element and pull up a voltage of the gate terminal based on an input signal;
a gate pull-down circuit configured to be connected to the gate terminal of the power semiconductor element and pull down the volage of the gate terminal based on the input signal;
an abnormality detection circuit configured to detect an abnormality of a conducting state of the power semiconductor element;
a minute current circuit configured to be connected to the gate terminal of the power semiconductor element and pull charges from gate capacitance of the power semiconductor element;
a voltage detection circuit configured to be connected to a collector terminal of the power semiconductor element and detect a collector voltage; and
a switch circuit configured to be connected between the gate pull-down circuit and an emitter terminal of the power semiconductor element,
wherein, when the abnormality detection circuit detects an abnormality, the gate pull-up circuit is interrupted, the gate pull-down circuit is brought in a conducting state, and charges are pulled from the gate capacitance of the power semiconductor element via the switch circuit, and
wherein, when the voltage detection circuit detects that the collector voltage increased by the pulling of the charges has exceeded a set value, the switch circuit is interrupted, and the charges are pulled by the minute current circuit.

2. The semiconductor device according to claim 1,
wherein the voltage detection circuit includes a voltage divider formed by resistors connected in series with each other, a reference voltage circuit that outputs a reference voltage having the set value, a comparator that compares a signal outputted from the voltage divider with the reference voltage, and a logic circuit that interrupts the switch circuit when the abnormality detection circuit detects an abnormality and when the comparator detects that the signal outputted from the voltage divider is larger than the reference voltage.

3. The semiconductor device according to claim 1,
wherein the voltage detection circuit includes a series circuit formed by a diode and a resistor connected in series with each other, a reference voltage circuit that outputs a reference voltage having the set value, a comparator that compares a signal outputted from the series circuit, the signal appearring when the collector voltage exceeds a withstand voltage of the diode, with the reference voltage, and a logic circuit that interrupts the switch circuit when the abnormality detection circuit detects an abnormality and when the comparator detects that signal outputted from the series circuit is larger than the reference voltage.

4. The semiconductor device according to claim 1,
wherein the minute current circuit is a resistor connected between the gate and emitter terminals of the power semiconductor element, or wherein
the minute current circuit is a constant current circuit connected between the gate and emitter terminals of the power semiconductor element.

5. The semiconductor device according to claim 1,
wherein the gate pull-up circuit is a switch having one end connected to a power supply circuit and another end connected to the gate terminal of the power semiconductor element, and
wherein, when an on-signal that turns on the power semiconductor element is inputted as the input signal and when an abnormality is not detected by the abnormality detection circuit, the switch allows a current to flow from the power supply circuit to the gate terminal of the power semiconductor element.

6. The semiconductor device according to claim 1,
wherein the gate pull-up circuit is a switch having one end connected to an input terminal that receives the input signal and another end connected to the gate terminal of the power semiconductor element,
wherein, when an on-signal that turns on the power semiconductor element is inputted as the input signal and when an abnormality is not detected by the abnormality detection circuit, the switch allows a current to flow through the gate terminal of the power semiconductor element based on the on-signal, and
wherein a diode that electrically connects the gate terminal of the power semiconductor element to the emitter terminal when an off-signal that turns off the power semiconductor element is inputted is connected to said one end and said another end of the switch.

7. The semiconductor device according to claim 1,
wherein the gate pull-down circuit is a transistor having one end connected to the gate terminal of the power semiconductor element and another end connected to the switch circuit,
wherein, when an off-signal that turns off the power semiconductor element is inputted as the input signal or when the abnormality detection circuit detects an abnormality, the transistor allows a current to flow from the gate terminal of the power semiconductor element to the switch circuit.

8. A semiconductor device that controls switching of a power semiconductor element, the semiconductor device comprising:
a gate pull-up circuit configured to be connected to a gate terminal of the power semiconductor element and pull up a volage of the gate terminal based on an input signal;
a gate pull-down circuit configured to be connected to the gate terminal of the power semiconductor element and pull down the volage of the gate terminal based on the input signal;
an abnormality detection circuit configured to detect an abnormality of a conducting state of the power semiconductor element;
a minute current circuit configured to be connected to the gate terminal of the power semiconductor element and pull charges from gate capacitance of the power semiconductor element;
a voltage detection circuit configured to be connected to the gate terminal of the power semiconductor element and detect a gate voltage; and
a switch circuit configured to be connected between the gate pull-down circuit and an emitter terminal of the power semiconductor element,
wherein, when the abnormality detection circuit detects an abnormality, the gate pull-up circuit is interrupted, the gate pull-down circuit is brought in a conducting state, and charges are pulled from the gate capacitance of the power semiconductor element via the switch circuit, and
wherein, when the voltage detection circuit detects that the gate voltage decreased by the pulling of the charges has fallen below a set value, the switch circuit is interrupted, and the charges are pulled by the minute current circuit.

9. The semiconductor device according to claim 8, wherein the voltage detection circuit also serves as the minute current circuit.

10. A semiconductor device that controls switching of a power semiconductor element, the semiconductor device comprising:
a gate pull-up circuit configured to be connected to a gate terminal of the power semiconductor element and pull up a volage of the gate terminal based on an input signal;
a gate pull-down circuit configured to be connected to the gate terminal of the power semiconductor element and pull down the volage of the gate terminal based on the input signal;
an abnormality detection circuit configured to detect an abnormality of a conducting state of the power semiconductor element;
a minute current circuit configured to be connected to the gate terminal of the power semiconductor element and pull charges from gate capacitance of the power semiconductor element;
a voltage detection circuit configured to be connected to a sense emitter terminal of the power semiconductor element and detect a value obtained by converting a collector current of the power semiconductor element into a voltage; and
a switch circuit configured to be connected between the gate pull-down circuit and an emitter terminal of the power semiconductor element,
wherein, when the abnormality detection circuit detects an abnormality, the gate pull-up circuit is interrupted, the gate pull-down circuit is brought in a conducting state, and charges are pulled from the gate capacitance of the power semiconductor element via the switch circuit, and
wherein, when the voltage detection circuit detects that the voltage corresponding to the collector current decreased by the pulling of the charges has fallen below a set value, the switch circuit is interrupted, and the charges are pulled by the minute current circuit.

11. A semiconductor device that controls switching of a power semiconductor element, the semiconductor device comprising:
a gate pull-up circuit configured to be connected to a gate terminal of the power semiconductor element and pull up a volage of the gate terminal based on an input signal;
a gate pull-down circuit configured to be connected to the gate terminal of the power semiconductor element and pull down the volage of the gate terminal based on the input signal;
an abnormality detection circuit configured to detect an abnormality of a conducting state of the power semiconductor element;
a minute current circuit configured to be connected to the gate terminal of the power semiconductor element and pull charges from gate capacitance of the power semiconductor element;
a voltage detection circuit configured to be connected to a collector terminal of the power semiconductor element and detect a collector voltage;
a first switch circuit configured to be connected between the gate pull-down circuit and an emitter terminal of the power semiconductor element and be brought in a conducting state in a normal operation; and
a second switch circuit configured to be connected between the gate pull-down circuit and the emitter terminal of the power semiconductor element and have larger resistance than the first switch circuit,
wherein, when the abnormality detection circuit detects an abnormality, the gate pull-up circuit is interrupted, the gate pull-down circuit is brought in a conducting state, the first switch circuit is interrupted, and charges are pulled from the gate capacitance of the power semiconductor element via the second switch circuit, and
wherein, when the voltage detection circuit detects that the collector voltage increased by the pulling of the charges has exceeded a set value, the second switch circuit is interrupted, and the charges are pulled by the minute current circuit.

12. A semiconductor device that controls switching of a power semiconductor element, the semiconductor device comprising:
a gate pull-up circuit configured to be connected to a gate terminal of the power semiconductor element and pull up a volage of the gate terminal based on an input signal;
a gate pull-down circuit configured to be connected to the gate terminal of the power semiconductor element and pull down the volage of the gate terminal based on the input signal;
an abnormality detection circuit configured to detect an abnormality of a conducting state of the power semiconductor element;
a minute current circuit configured to be connected to the gate terminal of the power semiconductor element and pull charges from gate capacitance of the power semiconductor element;
a voltage detection circuit configured to be connected to a gate terminal of the power semiconductor element and detect a gate voltage;
a first switch circuit configured to be connected between the gate pull-down circuit and an emitter terminal of the power semiconductor element and be brought in a conducting state in a normal operation; and
a second switch circuit configured to be connected between the gate pull-down circuit and the emitter terminal of the power semiconductor element and have larger resistance than the first switch circuit,
wherein, when the abnormality detection circuit detects an abnormality, the gate pull-up circuit is interrupted, the gate pull-down circuit is brought in a conducting state, the first switch circuit is interrupted, and charges are pulled from the gate capacitance of the power semiconductor element via the second switch circuit, and
wherein, when the voltage detection circuit detects that the gate voltage decreased by the pulling of the charges has fallen below a set value, the second switch circuit is interrupted, and the charges are pulled by the minute current circuit.

13. The semiconductor device according to claim 12, wherein the voltage detection circuit also serves as the minute current circuit.

14. A semiconductor device that controls switching of a power semiconductor element, the semiconductor device comprising:
a gate pull-up circuit configured to be connected to a gate terminal of the power semiconductor element and pull up a volage of the gate terminal based on an input signal;
a gate pull-down circuit configured to be connected to the gate terminal of the power semiconductor element and pull down the volage of the gate terminal based on the input signal;
an abnormality detection circuit configured to detect an abnormality of a conducting state of the power semiconductor element;
a minute current circuit configured to be connected to the gate terminal of the power semiconductor element and pull charges from gate capacitance of the power semiconductor element;
a voltage detection circuit configured to be connected to a sense emitter terminal of the power semiconductor element and detect a value obtained by converting a collector current of the power semiconductor element into a voltage;
a first switch circuit configured to be connected between the gate pull-down circuit and an emitter terminal of the power semiconductor element and be brought in a conducting state in a normal operation; and
a second switch circuit configured to be connected between the gate pull-down circuit and the emitter terminal of the power semiconductor element and have larger resistance than the first switch circuit,
wherein, when the abnormality detection circuit detects an abnormality, the gate pull-up circuit is interrupted, the gate pull-down circuit is brought in a conducting state, the first switch circuit is interrupted, and charges are pulled from the gate capacitance of the power semiconductor element via the second switch circuit, and
wherein, when the voltage detection circuit detects that the voltage corresponding to the collector current decreased by the pulling of the charges has fallen below a set value, the second switch circuit is interrupted, and the charges are pulled by the minute current circuit.

15. The semiconductor device according to any one of claims 1 to 14, further comprising the power semiconductor element.
